# EUROPÄISCHE PATENTSCHRIFT

(11) **EP 2 439 775 B1**
(45) Veröffentlichungstag und Bekanntmachung des Hinweises auf die Patenterteilung: **04.01.2017**
(21) Anmeldenummer: 11181080.0
(22) Anmeldetag: 13.09.2011
(51) Int. Cl.: H01L 23/433, H01L 23/40, H05K 7/20

(54) **Wärmeverteiler mit mechanisch gesichertem Wärmekopplungselement**
Heat distributor with mechanically secured heat coupling element
Dissipateur de chaleur doté d'un élément de couplage thermique sécurisé de manière mécanique

(30) Priorität: 08.10.2010 DE 202010014108 U
(43) Veröffentlichungstag der Anmeldung: 11.04.2012
(73) Patentinhaber: Congatec AG, 94469 Deggendorf (DE)
(72) Erfinder: Pfaffinger, Konrad, 94469 Deggendorf (DE)
(74) Vertreter: Grünecker Patent- und Rechtsanwälte PartG mbB

(56) Entgegenhaltungen:
- DE-A1- 19 811 603
- JP-A- S 601 850
- JP-A- H06 252 298
- US-A1- 2004 104 467
- US-A1- 2005 128 715

## Beschreibung

Die vorliegende Erfindung bezieht sich auf einen Wärmeverteiler zum Abführen von Wärme, die durch mindestens ein Wärme erzeugendes Leistungshalbleiterbauelement erzeugt wird. Insbesondere befasst sich die vorliegende Erfindung mit Wärmeverteilern, die neben einer verbesserten Wärmekopplung zwischen einem Chip und einem Kühlkörper auch eine flexible Kopplungsanordnung aufweist, die Toleranzen der Bauteile und des Montageprozesses ausgleichen kann.

Leistungshalbleiter werden beispielsweise auf Leiterplatten montiert, auf denen zusätzlich weitere Bauteile angebracht sind, die je nach Funktionalität der Leiterplatten variieren. Aufgrund der hohen Leistungsdichten, die heutzutage insbesondere im Zusammenhang mit Embedded-Computern auftreten, sind optimierte Kühllösungen erforderlich, um eine Zerstörung der Bauteile durch Überhitzung zu verhindern. Leiterplatten mit den Halbleiterbauelementen unterliegen dabei bestimmten Toleranzen, die bei der Montage der Kühlvorrichtung ausgeglichen werden sollten. Ein solcher Ausgleich von Toleranzen ist besonders bei Halbleiterbaugruppen wichtig, die in sogenannte Basisplatinen eingebaut werden. Solche Baugruppen werden üblicherweise "Computer on modules", COM-Lösungen genannt.

Die vorliegende Erfindung ist aber selbstverständlich für die Wärmeabfuhr bei beliebigen anderen elektronischen Komponenten, für die Kühlung von Halbleiterschaltern in Gleichund Wechselrichtern, sogenannten Power-Modules, wie auch allen beliebigen anderen Einsatzgebieten, in denen überschüssige Wärme abgeführt werden soll, verwendbar.

COM-Lösungen sind hochintegrierte CPU-Module, die zwar keine selbstständig lauffähigen Computer darstellen, jedoch die wichtigsten Funktionselemente eines Computers enthalten. Erst durch den Einbau der Module in eine Basisplatine erhalten sie ihre Funktionalität, wie beispielsweise als Messgerät, Steuercomputer oder für eine andere Applikation. Die Systemerweiterung und -anpassung wird ausschließlich über die Basisplatine ermöglicht, wodurch eine teilweise kundenspezifische integrierte Lösung entsteht. Die Basisplatine enthält alle erforderlichen Anschlüsse, um das System an Peripheriegeräte wie Festplatten, Maus oder Bildschirm anzuschließen. Ein COM-Modul enthält beispielsweise den Prozessor, einen Prozessorbus sowie einen oder mehrere Speicher (RAM) und kann je nach Hersteller auch eine gewisse Anzahl von Standardperipheriefunktionen übernehmen. COM-Module können als Steckkarten in eine Basisplatine eingebaut werden oder flächig über entsprechende Verbinder mit der Basisplatine verbunden werden.

COM-Module haben üblicherweise ein spezifiziertes Interface zur Anbindung an geeignete Kühllösungen. Dieses Interface wird nachfolgend Wärmeverteiler (englisch: Heatspreader) genannt, wobei auch andere Bezeichnungen geläufig sind, wie Wärmespreizplatte, Hitzeverteiler oder auch Kühlkörper. Der Wärmeverteiler wird dazu verwendet, im COM-Modul eine Wärmeabfuhr von den aktiven Hitze erzeugenden Bauteilen wie CPU oder Chip zu ermöglichen und die Wärme an eine weitere Kühllösung, wie einen Kühlkörper oder eine Gehäusewandung, weiterzuleiten.

Eine große Stärke von COM-Modulen ist deren freie Austauschbarkeit. Die thermische Anbindung des Moduls an eine weitere Kühllösung erfolgt somit immer über die Wärmeverteileroberfläche an der gleichen geometrischen Position. Um eine Austauschbarkeit innerhalb der Systemumgebung ohne mechanische Anpassungen zu gewährleisten, sind COM-Module daher in ihren Abmessungen, wie Höhe, Breite und Länge genau spezifiziert.

Toleranzen der Bauteile und Soll-Abweichungen während des Montageprozesses, beispielsweise durch den Lötprozess, erschweren die positionsgenaue Anbindung der Basisplatine zum Wärmeverteiler. Bei ungünstigen Toleranzen entstehen unerwünschte mechanische Belastungen an dem Schaltungsträger, beispielsweise einer Leiterplatte, und dem Wärmeverteiler, was im schlimmsten Fall zu einer Durchbiegung der Leiterplatte führen kann.

Daher ist bekannt, den Wärmeverteiler zumindest teilweise mit einem flexiblen Wärmekopplungselement auszustatten, das flexibel mit Bezug auf eine Grundplatte des Wärmeverteilers angeordnet ist, um Toleranzen in den Abmessungen des Leistungshalbleiterbauelements aufzufangen.

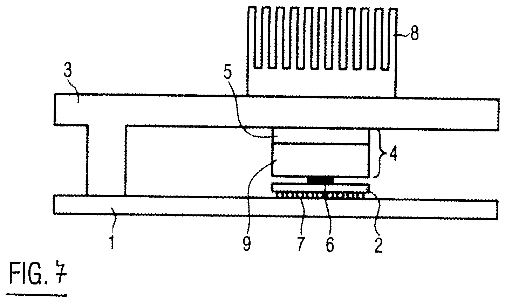

Fig. 7 zeigt in einer schematischen Schnittdarstellung eine Halbleitereinheit 10 mit einem Wärmeverteilter 3, wie sie beispielsweise aus der EP 1791177 A1 bekannt ist. Die Halbleitereinheit der Figur 7 wird üblicherweise in eine Basisplatine eingebaut, um eine anwendungsspezifische integrierte Lösung zu erzielen.

Ein Chip 2 mit einer aktiven und einer rückseitigen Fläche stellt hier den ausführenden Teil des CPU-Moduls dar, wobei die aktive Fläche des Chips 2 einen Prozessorkern 6 umfasst. Die rückseitige Fläche des Chips 2 ist auf einer Leiterplatte 1 montiert. Es können beispielsweise Lötkügelchen 7 verwendet werden, um den Chip elektrisch und fest mit der Leiterplatte zu verbinden. Der Chip 2 kann beispielsweise als oberflächenmontiertes (engl.= surface mounted device) Bauteil ausgeführt sein. Die "surface mount technology" SMT wird heute üblicherweise verwendet, da sie gegenüber früheren Verfahren zahlreiche Vorteile bietet. Das dabei verwendete Wiederaufschmelzlöten ist ein Weichlötverfahren, bei dem die Bauteile durch Weichlot und Lötpaste direkt auf einer Leiterplatte montiert werden. Allerdings sind darüber hinaus alle dem Fachmann geläufigen Techniken zur Montage eines Chips auf einer Leiterplatte möglich.

Während des Betriebs des COM-Moduls entsteht an dem Chip Hitze, die von dem Chip 2, inklusive Prozessorkern 6 abgeführt werden muss, um eventuelle Hitzeschäden an der Leiterplatte 1 und dem Chip 2 zu vermeiden. Ein Wärmeverteiler 3 ist über dem Chip 2 montiert und führt zum einen die Wärme vom Chip 2 ab und schützt zum anderen den Chip 2 vor möglichen Beschädigungen. Der Wärmeverteiler 3 ist mit der Leiterplatte lösbar verbunden.

Beispielsweise kann der Wärmeverteiler 3 durch entsprechende Befestigungsvorrichtungen mit Schrauben (nicht gezeigt) an die Leiterplatte montiert werden. Allerdings sind alle dem Fachmann geläufigen Montagemöglichkeiten, die eine lösbare Befestigung erlauben, ebenfalls denkbar. Darunter fallen beispielsweise auch Nieten-, Klammer- oder Klebebefestigungen (ebenfalls nicht gezeigt). Eine solche lösbare Montage hat den Vorteil, dass der Wärmeverteiler 3 ausgetauscht werden kann. Weiterhin kann für Reparaturarbeiten am Chip 2 der Wärmeverteiler 3 demontiert werden, wodurch der Chip 2 leichter erreichbar ist.

Um den Chip 2 thermisch an den Wärmeverteiler 3 anzubinden, wird eine thermisch leitfähige Wärmekopplungsanordnung 4 verwendet. Diese ist in Figur 7 zwischen der aktiven Fläche des Chips 2 und dem Wärmeverteiler 3 angeordnet, so dass eine direkte thermische Verbindung des wärmeerzeugenden Chips 2 mit dem Wärmeverteiler 3 hergestellt wird.

Die Halbleitereinheit wird als standardisierte Einheit in eine Basisplatine eingebaut und üblicherweise mit weiteren Kühllösungen des Systems verbunden. Eine solche Kühllösung ist in Figur 7 beispielhaft als eine Vielzahl von Kühlrippen 8 veranschaulicht. Andere Kühllösungen sind aber ebenfalls möglich. Dabei können alle dem Fachmann geläufigen Kühlkörper und Kühlprozesse Anwendung finden, wie beispielsweise eine Lüfter- oder Wasserkühlung. Weiters ist auch eine Wärmeabfuhr mittels zusätzlicher Heatpipes denkbar. Auch die Größe der Kontaktfläche zum Wärmeverteiler 3 ist je nach Systemumgebung geeignet zu wählen. Vorzugsweise liegt der Kühlkörper 8 an den vom Chip 2 abgewandten Seiten des Wärmeverteilers 3 an. Für die Funktion der vorliegenden Erfindung ist die verwendete Systemkühllösung 8 ohne große Bedeutung.

Eine standardisierte Anbindung an das System (Kühllösung, Basisplatine) erfordert genau spezifizierte Abmessungen der Halbleitereinheit. Bauteile werden zwar möglichst maßgenau gebaut, sind aber trotzdem gewissen Toleranzschwankungen unterworfen. Üblicherweise bewegen sich diese Toleranzen im Bereich von ± 0.2 mm. Darüber hinaus entstehen beispielsweise bei der Montage des Chips 2 auf der Leiterplatte 1 durch den Lötprozess Toleranzen. Diese Bau- und Montagetoleranzen erschweren zum einem die Anbindung an die Basisplatine, aber zum anderen auch die Montage der Halbleitereinheit.

Bei ungünstigen Toleranzkombinationen der Bauteile kann es zu mechanischen Belastungen kommen, die zu einer Durchbiegung der Leiterplatte 1 führen. Beispielsweise können große mechanische Belastungen bei großen positiven Toleranzen des Lötprozesses und/oder der Bauteile und bei einer nicht erfindungsgemäßen Wärmeanbindung an den Wärmeverteiler 3 auftreten. Bei der Anbindung an die Kühllösung 8 des Systems, hier beispielhaft eine Kühlrippe an derselben mechanischen Position, wird eine mechanische Kraft über den Wärmeverteiler 3 und die nicht erfindungsgemäße Wärmeanbindung auf den Chip 2 und damit auf die Leiterplatte 1 ausgeübt. Durch die mechanische Belastung wird die Leiterplatte 1 durchbogen, wobei dies durchaus zu Schäden führen kann.

Falls eine große negative Toleranz des Lötprozesses auftritt, so wird zwar keine mechanische Kraft auf die Leiterplatte ausgeübt, allerdings ist eine optimale Wärmeanbindung des Chips an die Systemkühllösung nicht gewährleistet. Es können Lücken zwischen der nicht erfindungsgemäßen Wärmeanbindung und dem Wärmeverteiler auftreten, welche die Wärmeabfuhr verschlechtern.

In einer Ausführungsform besteht die Wärmekopplungsanordnung 4 aus einem mehrschichtigen wärmeleitenden Block 4. Dabei umfasst die Wärmekopplungsanordnung erfindungsgemäß eine elastische Schicht 5. Diese elastische Schicht 5 ermöglicht einen Toleranzausgleich. Die mechanischen Belastungen die, wie oben erläutert, bei ungünstigen Toleranzen der Bauteile und des Lötprozesses auftreten können, werden von der elastischen Schicht 5 kompensiert. Die mechanische Kraft sorgt für eine Kompression der elastischen Schicht. Daher erfolgt keine Übertragung der Kraft auf die Leiterplatte 1 und somit auch keine Durchbiegung der Leiterplatte 1.

Da die elastische Schicht 5 komprimierbar ist, kann diese so ausgeführt sein, dass sie stets etwas dicker als nötig ist. Dadurch erfolgt immer eine lückenlose und damit uneingeschränkte Wärmeanbindung an den Wärmeverteiler 3, auch wenn, wie oben erläutert negative Toleranzen auftreten. In diesem Fall würde die elastische Schicht 5 weniger komprimiert werden als bei positiven Toleranzen des Lötprozesses und der Bauteile.

Die elastische Schicht 5 sollte eine möglichst große Fläche zum Wärmeverteiler 3 aufweisen und möglichst dünn sein, da die elastische Schicht 5 normalerweise eine schlechtere thermische Leitfähigkeit aufweist. Allerdings ist die Schicht bei abnehmender Dicke weniger elastisch und flexibel, wodurch eine größere Kraft nötig wäre, um Toleranzen auszugleichen. Deswegen muss ein Kompromiss zwischen thermischer Leitfähigkeit und Flexibilität gefunden werden.

Die elastische Schicht 5 kann dabei aus verschiedenen Materialien bestehen, solange diese gute Wärmeleiteigenschaften haben und ausreichend elastisch sind. Beispielhaft seien hier graphitgefüllte Silikone erwähnt. Jedoch können andere, dem Fachmann geläufige Materialien verwendet werden, die elastisch sind.

Zur besseren thermischen Anbindung der Wärmekopplungsanordnung 4 kann diese über eine dünne Schicht Wärmeleitpaste (nicht gezeigt), die einen geringen thermischen Übergangswiderstand besitzt, mit den Chip 2 verbunden werden.

Weiterhin ist bekannt, dass eine Schicht 9 des wärmeleitenden Blockes 4 aus Kupfer oder ähnlich gut wärmeleitenden Material besteht. Die Menge an thermischer Energie, welche die Kupferschicht aufnehmen kann, hängt von ihrem Volumen ab. Die Kupferschicht 9 liegt entweder direkt oder über eine dünne Schicht Wärmeleitpaste am Chip 2, beziehungsweise am Prozessorkern 6 an und nimmt dessen Hitze auf und gibt diese an weitere Schichten des wärmeleitenden Blockes 4 ab, in Figur 7 an die elastische Schicht 5. Diese wiederum gibt die Hitze an den Wärmeverteiler 3 weiter, der mit einer weiteren Kühltechnik 8 des Systems gekühlt wird.

Allerdings hat die Anordnung, die in der EP 1791177 A1 beschrieben ist, den Nachteil, dass die elastische Schicht 5 nur über eine Klebung mit dem Wärmeverteiler verbunden ist und dass bei Wärmebelastung oder Belastung durch Vibrationen die Gefahr des Verrutschens aus der gewünschten Position innerhalb einer durch eine Grundplatte des Wärmeverteilers definierten Ebene besteht. Im schlimmsten Fall ist dann kein ausreichender Kontakt zu dem Chip 2 mehr gegeben und dieser nimmt Schaden durch Überhitzung.

Die US 2005/128715 A1 bezieht sich auf ein Kühlsystem für eine integrierte Schaltung. Bei dieser Anordnung wird eine Kühlplatte über ein thermisch leitfähiges Erweiterungssegment mit dem IC verbunden. Zwischen der Oberfläche des IC und der Oberfläche des Erweiterungssegments ist ein dünnes, elastisch-kompressibles, thermisch leitfähiges, stoßabsorbierendes Pad angeordnet.

Die JP S60 1850 A offenbart eine Kühlkörperlösung, bei der ein Bauelement über eine von dem Kühlkörper hervorspringende und mit diesem verschraubt Feder thermisch kontaktiert wird. Die von dem IC ausgehende Wärme wird über die angepresste Feder zum Kühlkörper hin abgeführt.

Die DE 198 11 603 A1 bezieht sich auf eine Kühlvorrichtung zum Kühlen mehrerer auf eine Leiterplatte montierter elektrischer Bauelemente. Dabei wird eine aus Isoliermaterial hergestellte elastische Bahn so angeordnet, dass sie die Oberflächen der elektrischen Bauelemente berührt. Die elastische Bahn ist an der Kühlplatte so angeordnet, dass ein geschlossener Raum dazwischen gebildet ist, und in dem geschlossenen Raum sind wärmeleitende Federn angeordnet. Dadurch wird die elastische Bahn an die Oberflächen der elektrischen Bauelemente gedrückt, während zwischen der Kühlplatte und den Wärme leitenden Federn außerdem eine Schicht aus wärmeleitendem Fett vorgesehen ist, um die Wärme abzuführen.

Die JP H06 252298 A zeigt eine geschichtete Anordnung eines ungehäust auf einer Leiterplatte montierten Bauelements, das über eine Molybdän-Platte mit dem Schaltungsträger verbunden ist. Ein mit Kühlrippen versehener Federarm liegt an dem Bauelement über eine weitere Molybdän-Platte an und verbindet das Bauelement mit einer zweiten Leiterplatte.

Die US 2004/104467 A1 bezieht sich auf eine Schaltungsträgeranordnung, bei der integrierte Schaltungen über jeweils ein Pad aus thermisch leitfähigem phasenwechselndem Material mit einem Kühlkörper verbunden sind. Der Kühlkörper hat zum Kontaktieren unterschiedlich dicker integrierter Schaltungen entsprechend unterschiedlich weit vorspringende Sockel.

Die Aufgabe, die der vorliegenden Erfindung zugrunde liegt, besteht darin, eine verbesserte Wärmeableitung von einem wärmeerzeugenden Leistungshalbleiterbauelement, wie einer CPU oder einem Chipsatz, zum Wärmeverteiler zu ermöglichen, wobei der Wärmeverteiler kostengünstig herstellbar sein soll. Weiterhin soll eine möglichst positionsgenaue Anbindung des COM-Moduls an die Systemkühllösung bei möglichst geringen mechanischen Belastungen gewährleistet werden.

Diese Aufgabe wird gemäß der vorliegenden Erfindung durch einen Wärmeverteiler mit den Merkmalen des Anspruchs 1 gelöst.

Gemäß der vorliegenden Erfindung umfasst der Wärmeverteiler eine Grundplatte, die mit mindestens einem Leistungshalbleiterbauelement wärmeleitend verbindbar ist. Weiterhin weist der Wärmeverteiler mindestens ein Wärmekopplungselement auf, das mit dem mindestens einen Leistungshalbleiterbauelement einerseits und mit der Grundplatte andererseits wärmeleitend verbunden ist und mindestens eine elastische Schicht aufweist. Die elastische Schicht dient dem Ausgleich von Toleranzen, da sie unterschiedliche Bauhöhen der Leistungshalbleiterbauelemente durch Deformierung kompensiert.

Wie durch den Anspruch 1 definiert, umfasst das Wärmekopplungselement weiterhin mindestens ein Halteelement zum mechanischen Fixieren des Wärmekopplungselements mit Bezug auf eine durch die Grundplatte definierte Ebene. Dabei wird gemäß der vorliegenden Erfindung unter mechanischem Fixieren eine kleberfreie Halterung verstanden, die zusätzlich oder alternativ zur Verklebung vorgesehen ist. Im Unterschied zu dem klassischen Aufbau, bei dem der weich werdende Kleber zu einem Verrutschen des Wärmekopplungselements mit Bezug auf die Position des Chips führen kann, bietet die erfindungsgemäße mechanische Halterung den Vorteil, auch bei vibrationsreicher Umgebung und/oder erhöhter Temperatur die erforderliche Positionsgenauigkeit gewährleisten zu können.

Gemäß einer vorteilhaften Ausführungsform ist das Halteelement so ausgeführt, dass die elastische Schicht in einer Richtung quer zu der durch die Grundplatte definierten Ebene immer noch verformbar ist, und kann so ungehindert einen Toleranzausgleich in dieser Richtung vornehmen.

Auf besonders einfache Weise kann die erfindungsgemäße mechanische Sicherung dadurch erreicht werden, dass das Halteelement durch einen Einpressbolzen ohne Gewinde gebildet ist. Selbstverständlich können aber auch Vertiefungen in der Grundplatte oder geeignete Rahmenkonstruktionen den gewünschten Zweck erfüllen.

Insbesondere kann das Wärmekopplungselement jeweils durch zwei Einpressbolzen gehalten sein. Für ein Wärmekopplungselement mit rechteckiger Grundfläche werden diese beiden Einpressbolzen in vorteilhafter Weise in einander gegenüberliegenden Ecken der Grundfläche angeordnet. Selbstverständlich kann die mechanische Sicherung aber auch an beliebiger anderer Stelle, z. B. an einer oder mehreren Kanten, angeordnet sein.

Durch Vorsehen eines Wärmekopplungselements, das mit dem Leistungshalbleiterbauelement einerseits und mit der Grundplatte andererseits wärmeleitend verbunden ist, lässt sich eine Anpassung an vorhandene Toleranzen des Halbleiterbauelements und des Wärmeverteilers realisieren. Gleichzeitig kann das Wärmekopplungselement auch als Puffer dienen, um Temperaturspitzen abzufangen.

In vorteilhafter Weise kann dieses Wärmekopplungselement aus Kupfer hergestellt sein. Dieser Werkstoff hat den Vorteil, dass er eine besonders gute Wärmeleitfähigkeit besitzt. Andere metallische oder sonstigen gut wärmeleitenden Materialien sind natürlich ebenfalls verwendbar.

Ein kostengünstiges und gleichzeitig gut wärmeleitendes Material für die Grundplatte ist Aluminium. Selbstverständlich können aber auch andere wärmeleitende Materialien eingesetzt werden.

Um eine nochmals verbesserte Wärmekopplung zwischen dem Leistungshalbleiterbauelement und dem Wärmekopplungselement zu gewährleisten, kann noch eine zusätzliche wärmeleitende Zwischenschicht vorgesehen sein.

Diese Zwischenschicht kann weiterhin ein Latentwärmespeichermaterial umfassen. Unter Latentwärmespeicherung versteht man allgemein die Speicherung von Wärme in einem Material, welches einen Phasenübergang, vorwiegend fest/flüssig, erfährt (englisch: phase change material, PCM).

Neben dem Phasenübergang fest/flüssig können prinzipiell auch fest/fest Phasenübergänge eingesetzt werden. Diese zeigen in der Regel jedoch weit geringere Wärmespeicherdichten. Bei der Einspeicherung von Wärme in das Speichermaterial beginnt das Material bei Erreichen der Temperatur des Phasenübergangs zu schmelzen und erhöht dann trotz weiterer Einspeicherung von Wärme seine Temperatur nicht mehr, bis das Material komplett geschmolzen ist. Erst dann tritt wieder eine Erhöhung der Temperatur auf. Da für längere Zeit keine Temperaturerhöhung auftritt, bezeichnet man die während des Phasenübergangs eingespeicherte Wärme als versteckte Wärme oder latente Wärme. Dieser Effekt ermöglicht es, Temperaturschwankungen zu glätten und Temperaturspitzen, die den Halbleiter schädigen könnten, zu verhindern. Das Latentwärmespeichermaterial wird je nach Temperaturbereich gewählt. Meist kommen verschiedene Salze und deren eutektische Mischungen zum Einsatz.

In vorteilhafter Weise wird die Grundplatte so ausgeführt, dass sie mit einem zusätzlichen Kühlkörper oder einem Gehäuse verbindbar ist. Die Grundplatte und/oder das Wärmekopplungselement kann außerdem mit einer Nickelschicht oder einer Eloxalschicht versehen sein.

Zum besseren Verständnis der vorliegenden Erfindung wird diese anhand der in den nachfolgenden Figuren dargestellten Ausführungsbeispielen näher erläutert. Dabei werden gleiche Teile mit gleichen Bezugszeichen und gleichen Bauteilbezeichnungen versehen. Weiterhin können auch einige Merkmale und Merkmalskombinationen aus den gezeigten und beschriebenen Ausführungsformen für sich eigenständige erfinderische oder erfindungsgemäße Lösungen darstellen. Es zeigen:
- **Fig. 1**: eine perspektivische Darstellung eines Wärmeverteilers gemäß einer vorteilhaften Ausführungsform;
- **Fig. 2**: eine Draufsicht des Wärmeverteilers der Fig. 1;
- **Fig. 3**: eine Seitenansicht des Wärmeverteilers der Fig. 1;
- **Fig. 4**: eine weitere Draufsicht des Wärmeverteilers der Fig. 1;
- **Fig. 5**: eine weitere Seitenansicht des Wärmeverteilers der Fig. 1;
- **Fig. 6**: eine perspektivische Darstellung eines Wärmeverteilers gemäß einer weiteren vorteilhaften Ausführungsform;
- **Fig. 7**: eine schematische Schnittdarstellung einer Halbleitereinheit.

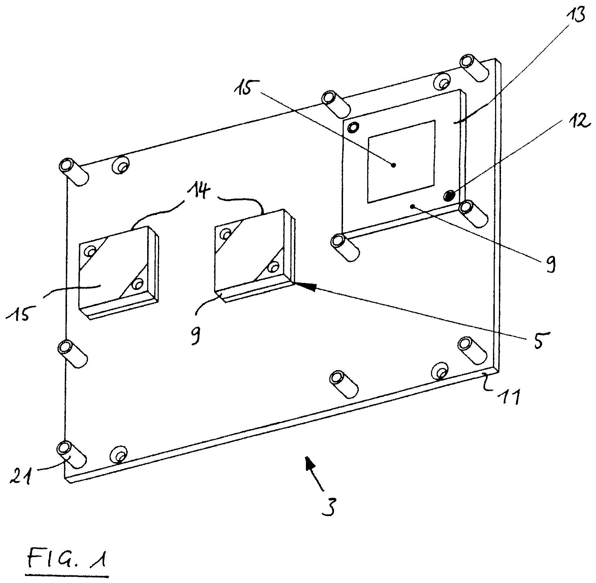

Fig. 1 zeigt in einer perspektivischen Darstellung die erfindungsgemäße Wärmeverteileranordnung 3, die in der Halbleitereinheit 10 aus Fig. 7 vorteilhaft zum Kühlen der Leistungshalbleiterbauelemente 2 eingesetzt werden kann. Der Wärmeverteiler 3 umfasst dabei eine Grundplatte 11, die beispielsweise aus Aluminium hergestellt sein kann. Damit an der Oberfläche der Grundplatte 11 keine störende Oxidschicht vorhanden ist, die ein Verlöten z.B. mit weiteren Schaltungskomponenten oder einem Kühlkörper verhindern würde, ist die Oberfläche der Grundplatte 11 beispielsweise vernickelt. Für einen Fachmann ist aber klar, dass die Wärmeverteilergrundplatte 11 aus allen weiteren für einen Fachmann üblichen Materialien, wie beispielsweise auch einer hochwärmeleitfähigen Keramik hergestellt sein kann.

Die Grundplatte 11 ist über Abstandshalter 21 mit einer Leiterplatte 1 verbindbar. Diese Abstandshalter 21 können beispielsweise durch Einpressbolzen mit Innengewinde gebildet sein.

Die in Fig. 1 gezeigte Wärmeverteileranordnung ist mit drei Wärmekopplungselementen 4 ausgestattet. Dabei ist ein erstes größerflächiges Wärmekopplungselement 13 für die thermische Kopplung mit einer CPU geeignet. Zwei weitere Wärmekopplungselemente 14 mit etwas geringerer Grundfläche sind für die Wärmeabfuhr von einem Interface Controller Hub und einem Graphic Memory Controller Hub ausgelegt. Selbstverständlich können die erfindungsgemäßen Prinzipien aber auch für beliebige andere Wärme erzeugenden Bauteile verwendet werden.

Jedes der Wärmekopplungselemente 13,14 ist durch einen Dreischicht-Aufbau gebildet. Ein Kupferkern 9 ist mit der Grundplatte 11 thermisch über eine elastische Schicht 5 gekoppelt. Diese elastische Schicht kann beispielsweise eine thermisch leitfähige Zwischenschicht gemäß dem US-Patent 5,679,457 der Firma "The Bergquist Company" sein.

Die elastische Schicht sorgt für den Toleranzausgleich über ihre Deformierbarkeit. Der Kupferkern ermöglicht eine Zwischenspeicherung und rasche Ableitung von erzeugter Wärme und ist mit dem Leistungshalbleiterbauelement über eine zusätzliche Latentwärmespeicherzwischenschicht 15 koppelbar. Erfindungsgemäß sind die Wärmekopplungselemente 4 über Einpressbolzen 12 mechanisch an der Grundplatte 11 fixiert. In vorteilhafter Weise sind die Einpressbolzen 12 in ihrer Länge so bemessen, dass eine ausreichende Deformierbarkeit der elastischen Zwischenschicht 5 beim Kontakt mit dem Chip möglich ist.

Weiterhin umfasst das Wärmekopplungselement 4 eine Zwischenschicht, die vorzugsweise aus einem Latentwärmespeichermaterial 15 gebildet ist und mit dem Chip in Anlage kommt. Dieses Latentwärmespeicherelement 15 dient als zusätzlicher Wärmepuffer zum Abdämpfen von Temperaturspitzen und kann beispielsweise mittels einer Klebung und/oder einer weiteren mechanischen Fixierung auf dem Wärmekopplungselement 4 gesichert werden. Derartige Latentwärmespeichermaterialien, wie sie im Zusammenhang mit der vorliegenden Erfindung verwendet werden können, sind beispielsweise in der US-Patentschrift 6,197,859 B1 beschrieben.

Aufgrund des geschichteten Aufbaus wird das Wärmekopplungselement 4 auch englisch als "Thermal Stack" bezeichnet. Bei der Fertigung werden zunächst die Einpressbolzen 12 und die Abstandshalter 21 mit Hilfe der entsprechenden Werkzeuge an der Grundplatte 11 befestigt. Die Thermal Stacks werden wie in Fig. 1 dargestellt zusammengefügt, anschließend unter Führung der als Zentrierstifte wirkenden Einpressbolzen 12 positioniert und über die Verklebung mit der elastischen Schicht 5 an der Grundplatte 11 fixiert.

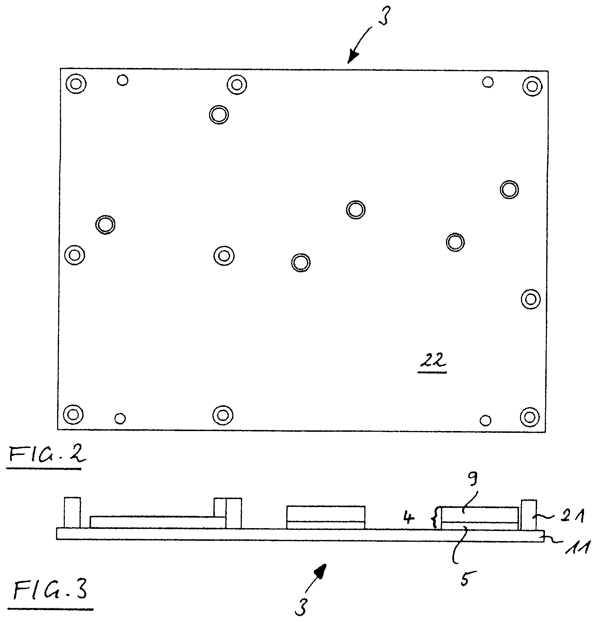

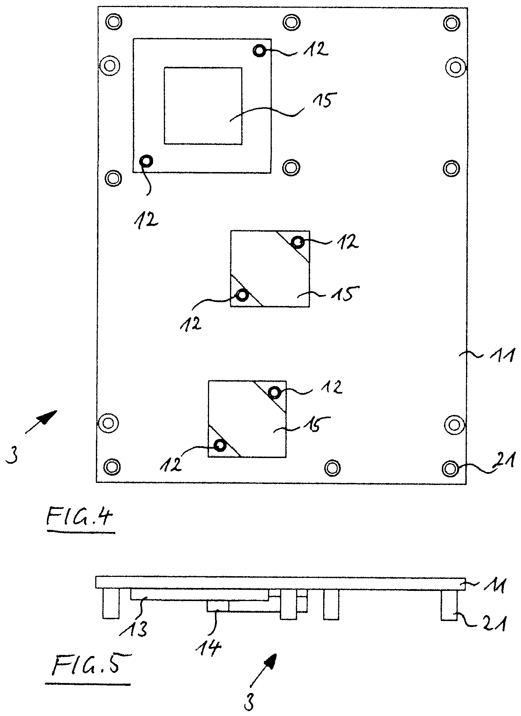

Die Fig. 2 bis 5 zeigen weitere Ansichten des erfindungsgemäßen Wärmeverteilers 3 der Fig. 1. Fig. 2 zeigt die den Leistungshalbleiterbauelementen 2 abgewandte Oberfläche 22 des Wärmeverteilers 3. Diese Oberfläche 22 ist in der gezeigten Ausführungsform so ausgestaltet, dass ein Kühlkörper oder auch ein Gehäuse in direkter Wärme ableitendem Kontakt mit dem Wärmeverteiler 3 gebracht werden kann. Alternativ kann aber auf der Oberfläche 22 auch eine strukturierte Geometrie, beispielsweise eine Kühlrippenoberfläche zur besseren Luftkühlung angebracht sein. Die jeweilige Ausgestaltung liegt im Belieben des Fachmanns und hängt von der gewünschten Applikationsumgebung ab.

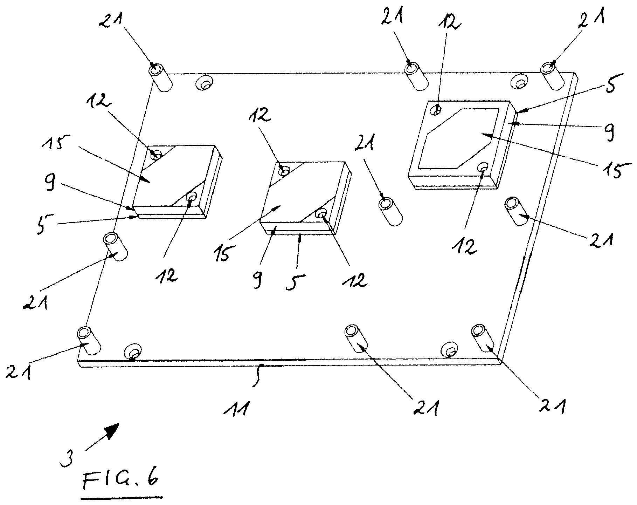

In Fig. 6 ist eine weitere vorteilhafte Ausführungsform eines Wärmeverteilers gezeigt, bei dem das Wärmekopplungselement 13 für die CPU ein Latentwärmespeicherelement 15 mit einer hexagonalen Grundfläche, ähnlich der Grundfläche der Latentwärmespeicherzwischenschicht 15 an den Wärmekopplungselementen 14, aufweist.

Im Vergleich zu Standard-Headspraeder-Platten wird bei der erfindungsgemäßen Lösung dafür gesorgt, dass mittels der Stifthalterung ein seitliches Entweichen des Wärmekopplungselements 4 oder auch nur der elastischen Schicht 5 verhindert wird. Auch unter mechanisch starker Belastung durch Vibrationen und Stoß kann selbst bei erhöhter Temperatur sichergestellt werden, dass alle Elemente des Wärmekopplungselements positionsgenau an ihrem Einbauort verbleiben.

Gemäß einer vorteilhaften Ausführungsform werden die Wärmekopplungselemente aus Kupfer hergestellt und mit einer Nickelschicht überzogen. Weitere Materialien, z. B. Aluminium oder Magnesium sowie Mehrschichtaufbauten, sind natürlich ebenfalls einsetzbar.

## Patentansprüche

1. Wärmeverteiler zum Abführen von Wärme, die durch mindestens ein wärmeerzeugendes Leistungshalbleiterbauelement (2) erzeugt wird, wobei der Wärmeverteiler (3) umfasst:
eine Grundplatte (11), die mit dem mindestens einen Leistungshalbleiterbauelement (2) wärmeleitend verbindbar ist;
mindestens ein geschichtetes Wärmekopplungselement (4), das mit dem mindestens einen Leistungshalbleiterbauelement (2) einerseits wärmeleitend verbindbar und mit der Grundplatte (11) andererseits wärmeleitend verbunden ist und mindestens eine elastische Schicht (5) aufweist;
wobei das Wärmekopplungselement (4) mindestens ein Halteelement zum mechanischen Fixieren des Wärmekopplungselements (4) mit Bezug auf eine durch die Grundplatte (11) definierte Ebene umfasst,
**dadurch gekennzeichnet, dass**
das geschichtete Wärmekopplungselement (4) unter Führung von mindestens einem als Zentrierstift wirkenden Einpressbolzen (12), der als das Halteelement wirkt, positioniert ist und mit der elastischen Schicht (5) an der Grundplatte (11) verklebt wird,
wobei das mindestens eine Halteelement so ausgeführt ist, dass die elastische Schicht in einer Richtung quer zu der durch die Grundplatte (11) definierten Ebene verformbar ist.

2. Wärmeverteiler nach Anspruch 1, wobei jedes Wärmekopplungselement (4) jeweils durch zwei Einpressbolzen (12) gehalten ist.

3. Wärmeverteiler nach Anspruch 2, wobei mindestens ein Wärmekopplungselement (4) jeweils eine rechteckige Grundfläche hat und die beiden Einpressbolzen (12) in einander gegenüberliegenden Ecken der Grundfläche angeordnet sind.

4. Wärmeverteiler nach einem der Ansprüche 1 bis 3, wobei das Wärmekopplungselement (4) mindestens einen Metallkern (9) umfasst, der aus Kupfer, Aluminium oder Magnesium gefertigt ist.

5. Wärmeverteiler nach einem der vorangehenden Ansprüche, wobei die Grundplatte (11) aus einem Metall gefertigt ist.

6. Wärmeverteiler nach Anspruch 5, wobei die Grundplatte (11) aus Aluminium gefertigt ist.

7. Wärmeverteiler nach einem der vorangehenden Ansprüche, wobei die Grundplatte (11) und/oder das Wärmekopplungselement (4) mit einer Oberflächenbeschichtung versehen sind.

8. Wärmeverteiler nach Anspruch 7, wobei die Grundplatte (11) und/oder das Wärmekopplungselement (4) mit einer Nickelschicht oder einer Eloxalschicht versehen sind.

9. Wärmeverteiler nach einem der vorangehenden Ansprüche, wobei zum Ankoppeln des mindestens einen Leistungshalbleiterbauelements (2) an dem Wärmekopplungselement eine wärmeleitende Zwischenschicht vorgesehen ist.

10. Wärmeverteiler nach Anspruch 9, wobei die Zwischenschicht ein Latentwärmespeichermaterial (15) umfasst.

11. Wärmeverteiler nach einem der vorangehenden Ansprüche, wobei die Grundplatte (11) mit einem Kühlkörper (8) verbindbar ist oder eine wärmeabgebende Oberflächenstruktur aufweist.

12. Wärmeverteiler nach einem der vorangehenden Ansprüche, wobei die Grundplatte (11) Kühlrippen aufweist.

## Claims

1. A heat spreader for dissipating heat generated by at least one heat-generating power semiconductor device (2), the heat spreader (3) comprising:
a base plate (11) which is connectable in a heat-conducting manner to the at least one power semiconductor device (2);
at least one layered heat coupling element (4) which on the one hand can be connected in a heat conducting manner to the at least one power semiconductor device (2) and is connected to the base plate (11) on the other hand, and comprises at least one elastic layer (5),
wherein the heat coupling element (4) comprises at least one holding element for mechanically fixing the heat coupling element (4) relative to a plane defined by the base plate (11),
**characterized in that**
the layered heat coupling element (4) is aligned under the guidance of at least one press-in bolt (12), the press-in bolt (12) acting as a centering pin and as the holding element, and is glued together with the elastic layer of the base plate (11),
wherein the at least one holding element is configured such that the elastic layer is deformable in a direction transverse to the plane defined by the base plate (11).

2. The heat spreader according to claim 1, wherein each heat coupling element (4) is held by two press-in bolts (12).

3. The heat spreader according to claim 2, wherein at least one heat coupling element (4) has a respective rectangular base area and the two press-in bolts (12) are arranged in corners of the base area that are opposite each other.

4. The heat spreader according to any one of claims 1 to 3, wherein the heat coupling element (4) comprises at least one metal core (9) which is made from copper, aluminum or magnesium.

5. The heat spreader according to any one of the preceding claims, wherein the base plate (11) is made from a metal.

6. The heat spreader according to claim 5, wherein the base plate (11) is made from aluminum.

7. The heat spreader according to any one of the preceding claims, wherein the base plate (11) and/or the heat coupling element (4) is/are provided with a surface coating.

8. The heat spreader according to claim 7, wherein the base plate (11) and/or the heat coupling element (4) are provided with a nickel layer or an eloxal layer.

9. The heat spreader according to any one of the preceding claims, wherein a heat-conducting interlayer is provided for coupling the at least one power semiconductor device (2) to the heat coupling element.

10. The heat spreader according to claim 9, wherein the interlayer comprises a latent-heat storage material (15).

11. The heat spreader according to any one of the preceding claims, wherein the base plate (11) is connectable to a heat sink (8) or comprises a heat-discharging surface structure.

12. The heat spreader according to claim 11, wherein the base plate (11) comprises cooling fins.

## Revendications

1. Dissipateur de chaleur destiné à évacuer la chaleur qui est générée par au moins un composant semiconducteur de puissance (2) produisant de la chaleur, le dissipateur de chaleur (3) comprenant :
une plaque de base (11) qui peut être mise en liaison conductrice de chaleur avec l'au moins un composant semiconducteur de puissance (2) ;
au moins un élément de couplage thermique (4) stratifié qui, d'une part, peut être mis en liaison conductrice de chaleur avec l'au moins un composant semiconducteur de puissance (2) et qui, d'autre part, est en liaison conductrice de chaleur avec la plaque de base (11) et possède au moins une couche élastique (5) ;
l'élément de couplage thermique (4) comprenant au moins un élément de maintien destiné à la fixation mécanique de l'élément de couplage thermique (4) en référence à un plan défini par la plaque de base (11),
**caractérisé en ce que**
l'élément de couplage thermique (4) stratifié est positionné en étant guidé par au moins un goujon à enfoncer (12) faisant office de goupille de centrage et agissant comme un élément d'arrêt, et il est collé à la plaque de base (11) par la couche élastique (5),
l'au moins un élément d'arrêt étant exécuté de telle sorte que la couche élastique peut être déformée dans une direction transversale par rapport au plan défini par la plaque de base (11).

2. Dissipateur de chaleur selon la revendication 1, chaque élément de couplage thermique (4) étant respectivement maintenu par deux goujons à enfoncer (12).

3. Dissipateur de chaleur selon la revendication 2, au moins un élément de couplage thermique (4) possédant respectivement une surface de base parallélépipédique et les deux goujons à enfoncer (12) étant disposés dans des coins mutuellement opposés de la surface de base.

4. Dissipateur de chaleur selon l'une des revendications 1 à 3, l'élément de couplage thermique (4) comprenant au moins un noyau métallique (9) qui est fabriqué en cuivre, en aluminium ou en magnésium.

5. Dissipateur de chaleur selon l'une des revendications précédentes, la plaque de base (11) étant fabriquée en un métal.

6. Dissipateur de chaleur selon la revendication 5, la plaque de base (11) étant fabriquée en aluminium.

7. Dissipateur de chaleur selon l'une des revendications précédentes, la plaque de base (11) et/ou l'élément de couplage thermique (4) étant munis d'un revêtement de surface.

8. Dissipateur de chaleur selon la revendication 7, la plaque de base (11) et/ou l'élément de couplage thermique (4) étant munis d'une couche de nickel ou d'une couche anodisée.

9. Dissipateur de chaleur selon l'une des revendications précédentes, une couche intermédiaire conductrice de chaleur étant présente pour le couplage de l'au moins un composant semiconducteur de puissance (2) à l'élément de couplage thermique.

10. Dissipateur de chaleur selon la revendication 9, la couche intermédiaire comprenant un matériau régulateur thermique à changement d'état (15).

11. Dissipateur de chaleur selon l'une des revendications précédentes, la plaque de base (11) pouvant être reliée à un radiateur (8) ou possédant une structure de surface dissipatrice de chaleur.

12. Dissipateur de chaleur selon l'une des revendications précédentes, la plaque de base (11) possédant des ailettes de refroidissement.
